(19) Europäisches Patentamt
European Patent Office
Office européen des brevets

(11) EP 3 026 014 A1

(12) # EUROPEAN PATENT APPLICATION
published in accordance with Art. 153(4) EPC

(43) Date of publication:
**01.06.2016 Bulletin 2016/22**

(21) Application number: **14830152.6**

(22) Date of filing: **17.07.2014**

(51) Int Cl.:
***C01B 31/02*** (2006.01) ***B82Y 15/00*** (2011.01)
***B82Y 30/00*** (2011.01) ***H01L 29/06*** (2006.01)
***H01L 29/786*** (2006.01) ***H01L 51/05*** (2006.01)
***H01L 51/30*** (2006.01)

(86) International application number:
**PCT/JP2014/069003**

(87) International publication number:
**WO 2015/012186 (29.01.2015 Gazette 2015/04)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **25.07.2013 JP 2013154334**
**09.04.2014 JP 2014079962**

(71) Applicant: **Toray Industries, Inc.**
**Tokyo, 103-8666 (JP)**

(72) Inventors:
- **MURASE, Seiichiro**
**Otsu-shi**
**Shiga 520-8558 (JP)**
- **ISOGAI, Kazuki**
**Otsu-shi**
**Shiga 520-8558 (JP)**
- **SHIMIZU, Hiroji**
**Otsu-shi**
**Shiga 520-8558 (JP)**

(74) Representative: **Hoefer & Partner Patentanwälte mbB**
**Pilgersheimer Straße 20**
**81543 München (DE)**

(54) **CARBON NANOTUBE COMPOSITE, SEMICONDUCTOR DEVICE, AND SENSOR USING SAME**

(57) A carbon nanotube composite in which an organic group is deposited on at least a portion of the surface, the carbon nanotube composite comprising at least one functional group selected from the group consisting of a hydroxyl group, a carboxy group, an amino group, a mercapto group, a sulfo group, a phosphonic acid group, and organic salts or inorganic salts thereof, as well as a formyl group, a maleimide group, and a succinimide group.

FIG. 2

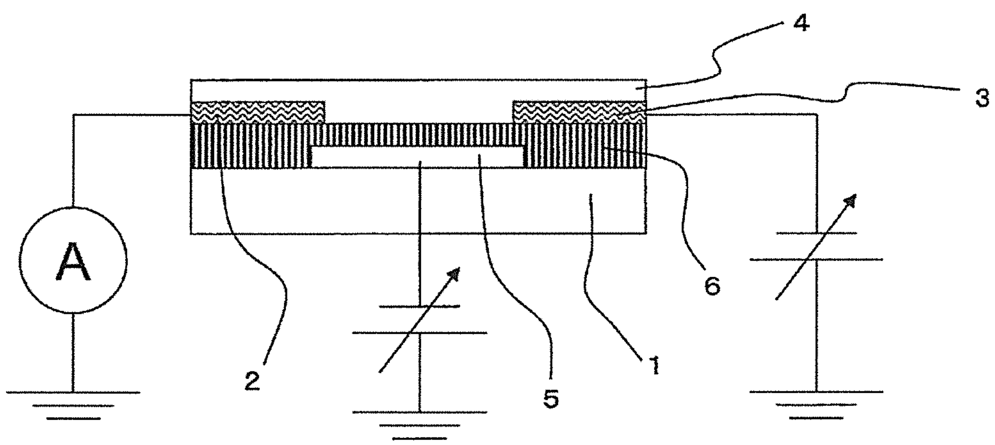




Printed by Jouve, 75001 PARIS (FR)

## Description

### TECHNICAL FIELD

The present invention relates to a carbon nanotube composite applicable to sensors such as biosensor, a semiconductor device, and a sensor using the same.

### BACKGROUND ART

A semiconductor device such as transistor, memory and condenser is used in various electronics, e.g., a display or a computer, by making use of its semiconductor properties. Development of, for example, IC tags or sensors utilizing the electrical properties of a field-effect transistor (hereinafter, FET) is also pursued. Among others, in view of non-necessity of labeling with a phosphor, etc., rapid electrical signal conversion and easy connection with an integrated circuit, an FET-type biosensor for detecting a biological reaction by using FET is being aggressively studied.

A biosensor using FET conventionally has a structure where a gate electrode is removed from an MOS (metal-oxide-semiconductor)-type FET and an ion-sensitive film is deposited on an insulating film, and this is also called an ion-sensitive FET sensor. The sensor is designed to function as various biosensors by disposing a biomolecular recognition substance on the ion-sensitive film (see, for example, Patent Document 1). However, its application to, for example, an immunosensor utilizing an antigen-antibody reaction requiring high detection sensitivity is not yet to be realized in practice due to technical limitation in the detection sensitivity. In addition, the process of forming a film of an inorganic semiconductor such as silicon requires an expensive production apparatus, making the cost reduction difficult, and furthermore, since the process is performed at a very high temperature, there is a problem that the kind of the material usable as a substrate is limited and a lightweight resin substrate, etc. cannot be used.

On the other hand, FET using a carbon nanotube (hereinafter, referred to as CNT) having high mechanical or electrical properties is known, and a sensor utilizing the electrical properties of CNT-FET has been developed. For example, a sensor using CNT that has been grown directly on a substrate is disclosed as an example utilizing single CNT (see, for example, Patent Documents 2 and 3). In addition, as the method for immobilizing a biomolecular recognition substance directly on CNT, there is disclosed a method where CNT is dispersed in heavy water by using sodium dodecylsulfate (SDS) as a dispersant and CNT immersed in a synthesized oligonucleotide solution is used (see, for example, Non-Patent Document 1).

### PRIOR ART

### PATENT DOCUMENT

Patent Document 1: JP-A-2007-108160
Patent Document 2: JP-A-2005-229017
Patent Document 3: JP-A-2005-79342

### NON-PATENT DOCUMENT

Non-Patent Document 1: JOURNAL OF AMERICAN CHEMICAL SOCIETY, vol. 129, pp. 14427-14432 (2007)

### SUMMARY OF THE INVENTION

### PROBLEMS THAT THE INVENTION IS TO SOLVE

In the techniques described in Patent Documents 2 and 3, one CNT is used and this makes it difficult to control the variation among devices. In addition, since a biomolecular recognition substance is disposed on an insulating film and the interaction with a detection substance is detected indirectly, there is a limitation in increasing the sensitivity.

In the technique described in Non-Patent Document 1, the application target is limited to a specific oligonucleotide having affinity for CNT. In addition, the insulating dispersant reduces the electrical properties of CNT, and sufficient detection sensitivity can be hardly obtained.

Considering these problems, an object of the present invention is to provide a carbon nanotube composite that can be produced at a low cost through a simple coating process and be applied to a wide variety of sensing target substances and makes it possible to obtain high detection sensitivity, a semiconductor device, and a sensor using the

same.

MEANS FOR SOLVING PROBLEMS

In order to solve the above problem, the following constitutions are included in the present invention. That is, a carbon nanotube composite has an organic substance attached to at least a part of a surface thereof, and at least one functional group selected from the group consisting of a hydroxyl group, a carboxy group, an amino group, a mercapto group, a sulfo group, a phosphonic acid group, an organic or inorganic salt thereof, a formyl group, a maleimide group and a succinimide group is contained in at least a part of the carbon nanotube composite.

In addition, in the present invention, a semiconductor device includes a substrate, a first electrode, a second electrode, and a semiconductor layer, and the first electrode is disposed with spacing from the second electrode, the semiconductor layer is disposed between the first electrode and the second electrode, and the semiconductor layer contains the carbon nanotube composite.

In addition, in the present invention, a sensor includes the semiconductor device.

ADVANTAGE OF THE INVENTION

According to the present invention, a sensor producible at a low cost through a simple coating process and having high sensing properties can be provided.

BRIEF DESCRIPTION OF THE DRAWINGS

[FIG. 1] A schematic cross-sectional view showing a semiconductor device as one embodiment of the present invention.

[FIG. 2] A schematic cross-sectional view showing a semiconductor device as one embodiment of the present invention.

[FIG. 3] A graph showing the current value flowing between a first electrode and a second electrode when streptavidin, BSA and IgE are added to the semiconductor layer of the semiconductor device shown in one Example of the present invention.

[FIG. 4] A graph showing the current value flowing between a first electrode and a second electrode when streptavidin, BSA and IgE are added to the semiconductor layer of the semiconductor device shown in one Example of the present invention.

[FIG. 5] A graph showing the current value flowing between a first electrode and a second electrode when IgE, BSA and avidin are added to the semiconductor layer of the semiconductor device shown in one Example of the present invention.

MODE FOR CARRYING OUT THE INVENTION

In the carbon nanotube (hereinafter, referred to as CNT) composite in the present invention, an organic substance is attached to at least a part of the surface, and at least one functional group selected from the group consisting of a hydroxyl group, a carboxy group, an amino group, a mercapto group, a sulfo group, a phosphonic acid group, an organic or inorganic salt thereof, a formyl group, a maleimide group and a succinimide group is contained in at least a part of the CNT composite.

(CNT Composite)

The state of an organic substance being attached to at least a part of the surface of CNT means a state where the surface of CNT is partially or entirely coated with an organic substance. It is presumed possible for an organic substance to coat CNT through a hydrophobic interaction or in the case where the organic substance has a conjugated structure, through an interaction occurring due to overlapping of n electron clouds derived from respective conjugated structures of the organic substance and CNT. When CNT is coated with an organic substance, the reflected color of CNT changes close to color of the conjugated polymer from the color of uncoated CNT, so that whether coated or not can be judged. Quantitatively, the presence of an attached substance and the weight ratio of the attached substance relative to CNT can be identified by the elemental analysis such as X-ray photoelectron spectroscopy (XPS).

In the CNT composite in the present invention, an organic substance is attached to at least a part of the surface of CNT, whereby CNT can be uniformly dispersed in a solution without damage of the high electrical properties possessed

by CNT. In addition, a uniformly dispersed CNT film can be formed by a coating method from a solution in which CNT is uniformly dispersed. As a result, high semiconductor properties can be realized.

As the method for attaching an organic substance to CNT, examples thereof include, for example, (I) a method of adding CNT to a melted organic substance and mixing them, (II) a method of dissolving an organic substance in a solvent, adding CNT thereto, and mixing them, (III) a method of previously pre-dispersing CNT with ultrasonic waves, etc., adding an organic substance thereto, and mixing them, and (IV) a method of adding an organic substance and CNT into a solvent and mixing them by irradiating the mixed system with ultrasonic waves. In the present invention, any of these methods may be used, and some methods may be combined.

The organic substance is not particularly limited, and specific examples thereof include, for example, polyvinyl alcohol, celluloses such as 89 carboxymethyl cellulose, polyalkylene glycols such as polyethylene glycol, acrylic resins such as polyhydroxymethyl methacrylate, conjugated polymers such as poly-3-hexylthiophene, polycyclic aromatic compounds such as anthracene derivative and pyrene derivative, and long-chain alkyl organic salts such as sodium dodecylsulfate and sodium cholate. In view of interaction with CNT, those having a hydrophobic group such as alkyl group or aromatic hydrocarbon group or having a conjugated structure are preferred, and a conjugated polymer is more preferred. When the organic substance is a conjugated polymer, the effect of uniformly dispersing CNT in a solution or the effect such as high semiconductor properties is more enhanced without deteriorating high electrical properties possessed by CNT.

(Functional Group)

In the CNT composite in the present invention, at least one functional group selected from the group consisting of a hydroxyl group, a carboxy group, an amino group, a mercapto group, a sulfo group, a phosphonic acid group, an organic or inorganic salt thereof, a formyl group, a maleimide group and a succinimide group is contained in at least a part of the composite, whereby detection of a sensing target substance is facilitated. More specifically, such a functional group interacts with the sensing target substance through chemical bonding, hydrogen bonding, ionic bonding, coordination boding, electrostatic interaction, oxidation/reduction reaction, etc. to cause a change in the electrical properties of CNT existing in the neighborhood, and the change can be detected as an electrical signal.

Of those functional groups, the amino group, maleimide group and succinimide group may or may not have a substituent, and examples of the substituent include, for example, an alkyl group. This substituent may be further substituted.

The organic salt in the functional group above is not particularly limited, and examples thereof include, for example, an ammonium salt such as tetramethylammonium salt, a pyridinium salt such as N-methylpyridinium salt, an imidazolium salt, a carboxylate such as acetate, a sulfonate, and a phosphonate.

The inorganic salt in the functional group above is not particularly limited, and examples thereof include, for example, a carbonate, an alkali metal salt such as sodium salt, an alkaline earth metal salt such as magnesium salt, a salt composed of a transition metal ion such as copper, zinc and iron, a salt composed of a boron compound, such as tetrafluoroborate, a sulfate, a phosphate, a hydrochloride, and a nitrate.

The configuration of introduction of a functional group into the CNT composite may be a configuration where the functional group is included in a part of the organic substance attached to the surface of CNT, or a configuration where another compound different from the above-described organic substance is attached to the surface of CNT and the functional group is included in a part of the compound. As the another compound having the functional group, examples thereof include, for example, stearylamine, laurylamine, hexylamine, 1,6-diaminohexane, diethylene glycol bis(3-aminopropyl) ether, isophoronediamine, 2-ethylhexylamine, stearic acid, lauric acid, sodium dodecylsulfate, Tween 20, 1-pyrenecarboxylic acid, 1-aminopyrene, 1-hexabenzoeolonenecarboxylic acid, 1-aminohexabenzocoronene, 1-hexabenzocoronenebutanecarboxylic acid, 1-pyrenebutanecarboxylic acid, 4-(pyren-1-yl)butane-1-amine, 4-(pyren-1-yl)butan-1-ol, 4-(pyren-1-yl)butane-1-thiol, 4-(hexabenzocoronen-1-yl)butane-1-amine, 4-(hexabenzocoronen-1-yl)butan-1-ol, 4-(hexabenzocoronen-1-yl)butane-1-thiol, 1-pyrenebutanoic acid *N*-hydroxysuccinimide ester, 1-hexabenzocoronenebutanoic acid *N*-hydroxysuccinimide ester, biotin, biotin-N-hydroxysuccinimide ester, biotin-N-hydroxy-sulfosuccinimide ester, polyethyleneimine, polyethylene glycol, polyvinyl alcohol, polyacrylic acid, sodium polyacrylate, polyacrylamine, polyacrylamine hydrochloride, polymethacrylic acid, sodium polymethacrylate, polymethacrylamine, polymethacrylamine hydrochloride, alginic acid, sodium alginate, glucose, maltose, sucrose, chitin, amylose, amylopectin, cellulose, carboxymethyl cellulose, sucrose, lactose, bovine serum albumin, human immunoglobulin E, human immunoglobulin G, avidin, streptavidin, cholic acid, sodium cholate, deoxycholic acid, sodium deoxycholate, cholesterol, cyclodextrin, xylan, catechin, poly-3-(ethylsulfonic acid-2-yl)thiophene, poly-3-(ethanoic acid-2-yl)thiophene, poly-3-(2-aminoethyl)thiophene, poly-3-(2-hydroxyethyl)thiophene, poly-3-(2-mercaptoethyl)thiophene, polystyrenesulfonic acid, polyvinylphenol, polyoxypropylene triol, glutaraldehyde, ethylene glycol, ethylenediamine, poly-1H-(propionic acid-3-yl)pymole, 1-adamantanol, 2-adamantanol, 1-adamantanecarboxylic acid, dodecylbenzenesulfonic acid, sodium dodecylbenzenesulfonate, and N-ethylmaleimide. These compounds may be used individually, or two or more kinds of

compounds may be used in combination.

(Conjugated Polymer)

In the present invention, as the conjugated polymer which is one preferable example of the organic substance attached to at least a part of the CNT surface, examples thereof include a polythiophene-based polymer, a polypyrrole-based polymer, a polyaniline-based polymer, a polyacetylene-based polymer, a poly-p-phenylene-based polymer, a poly-p-phenylenevinylene-based polymer, etc. but the conjugated polymer is not particularly limited thereto. As the polymer above, a polymer where single monomer units are arranged is preferably used, but a polymer where different monomer units are block-copolymerized or random-copolymerized is also used. In addition, a polymer obtained by graft polymerization may also be used. Among the polymers above, a polythiophene-based polymer capable of readily forming a CNT composite due to ease of attachment to CNT is preferably used in the present invention. The molecular weight is preferably from 800 to 100,000 in terms of number average molecular weight. The polymer need not necessarily have a high molecular weight and may be an oligomer composed of a linear conjugated system.

It is preferred that the conjugated polymer has a side chain and at least one functional group selected from the group consisting of a hydroxyl group, a carboxy group, an amino group, a mercapto group, a sulfo group, a phosphonic acid group, an organic or inorganic salt thereof, a formyl group, a maleimide group and a succinimide group is contained in at least a part of the side chain. Furthermore, another compound having the functional group may be attached to at least a part of the CNT surface.

The side chain as used in the present invention indicates a chain containing at least one carbon atom substituted on and linked to an atom constituting the main chain of the conjugated polymer. In addition, containing the functional group in the side chain means to contain the functional group at the terminal of the side chain or contain the functional group on a branch diverging from the side chain. Furthermore, the chain indicates a chain formed by linking two or more atoms in series. At this time, one of elements contained in the functional group may be caused to be contained in the elements constituting the chain. Accordingly, for example, when a group represented by $CH_2$-COOH is linked to the main chain, this group is a side chain containing a carboxyl group.

The side chain above preferably contains an alkylene group in at least a part of the chain. The alkylene group may be bonded directly to an atom constituting the conjugated polymer that is the main chain, or may be bonded through an ether bond, an ester bond, etc.

The alkylene group here indicates, for example, a divalent saturated aliphatic hydrocarbon group such as methylene group, ethylene group, n-propylene group, isopropylene group, n-butylene group, sec-butylene group, tert-butylene group, cyclopropylene group, cyclohexylene group and norbomylene group, and may or may not have a substituent. In the case of having a substituent, the additional substituent is not particularly limited and examples thereof include, for example, an alkyl group and an alkoxy group such as methoxy group and ethoxy group, and the additional substituent may further have a substituent. The carbon number of the alkylene group is not particularly limited but in view of ease of availability or cost, is preferably 1 or more and 20 or less, more preferably 1 or more and 8 or less.

As the conjugated polymer having the functional group above in the side chain, specific examples thereof include the following structures. In each structure, n represents the number of repetitions and is from 2 to 1,000. The conjugated polymer may be a homopolymer of each of these structures, may be a copolymer of the structures, or may be a copolymer of each structure and a structure formed by removing the side chain from the structure.

[Chem. 1]

(1) 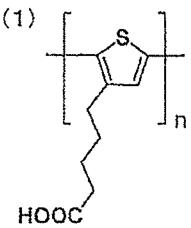

(2) 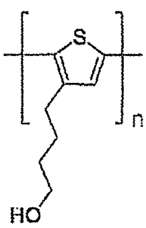

(3) 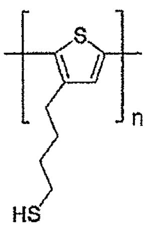

(4) 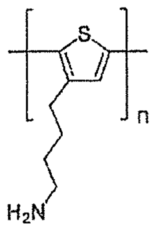

(5)

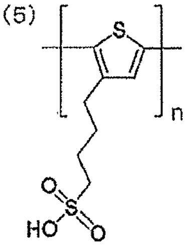

(6)

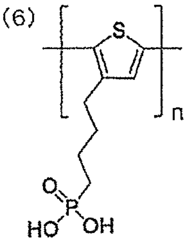

(7)

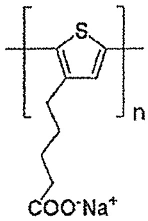

(8)

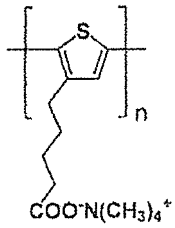

(9)

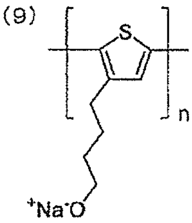

(10)

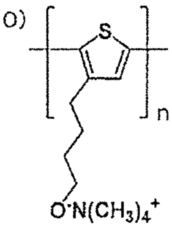

(11)

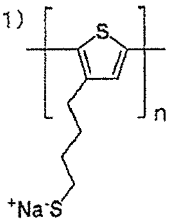

(12)

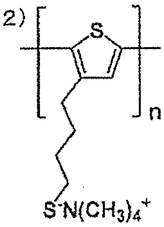

(13)

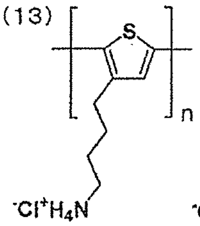

(14)

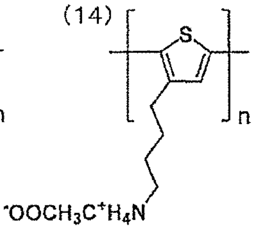

(15)

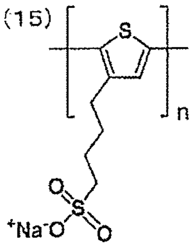

(16)

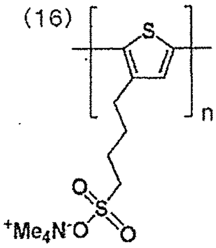

(17)

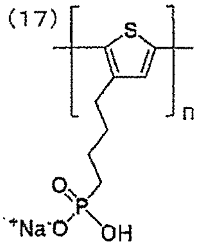

(18)

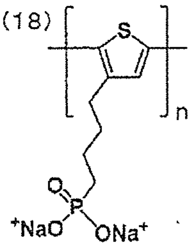

(19)

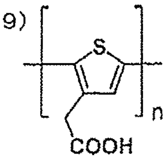

(20)

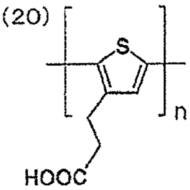

[Chem. 2]

(21)
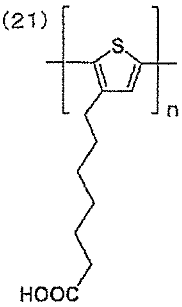
(22)
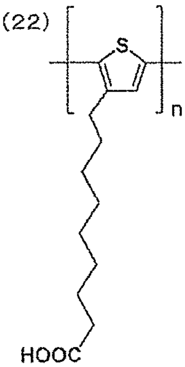
(23)
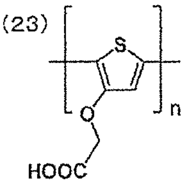
(24)
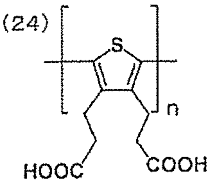
(25)
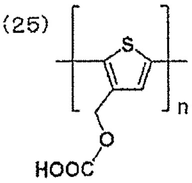
(26)
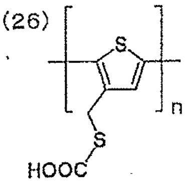
(27)
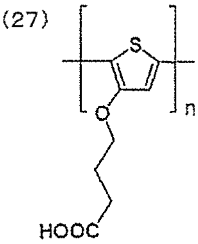
(28)
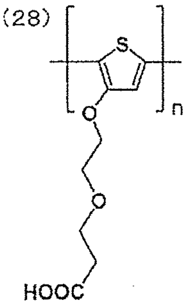
(29)
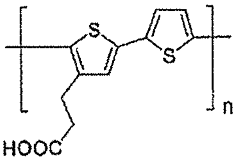
(30)
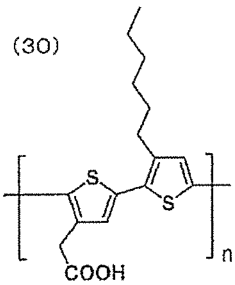
(31)
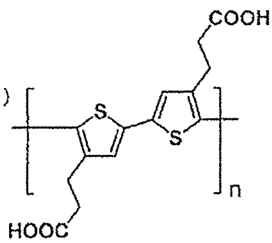
(32)
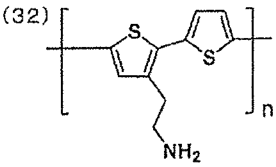
(33)
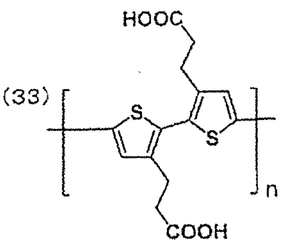
(34)
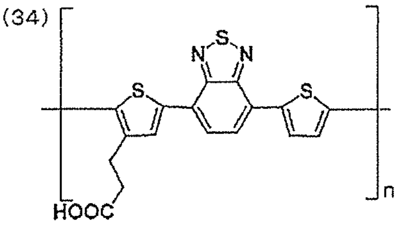
(35)
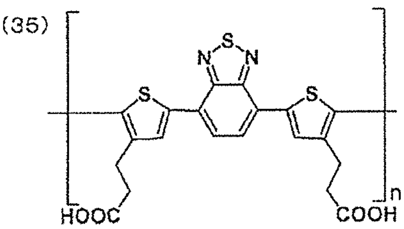

[Chem. 3]

(36)
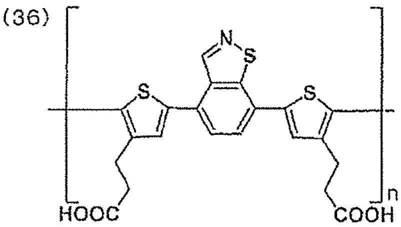
(37)
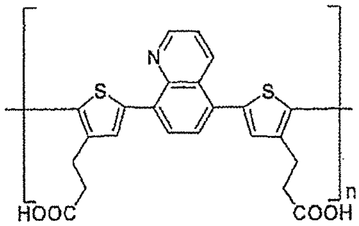

(38)
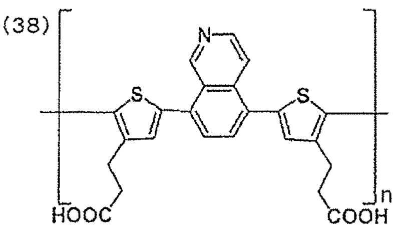

(39)
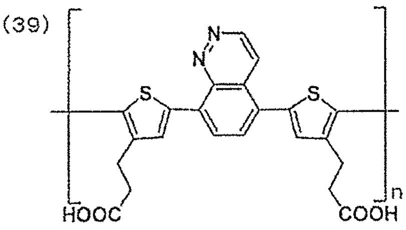

(40)
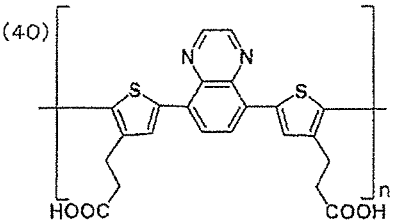

(41)
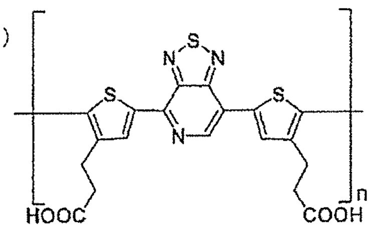

(42)
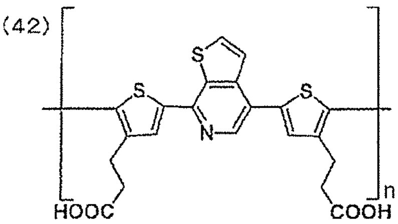

(43)
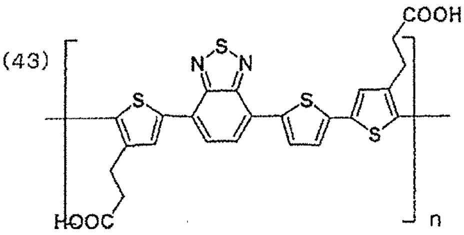

[Chem. 4]

(44)
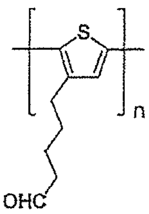

(45)
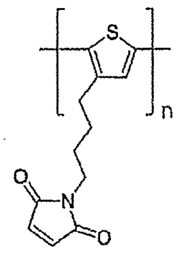

(46)
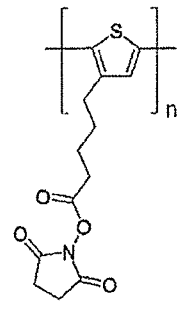

(47)
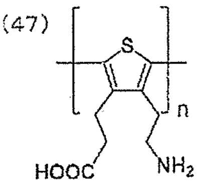

(48)
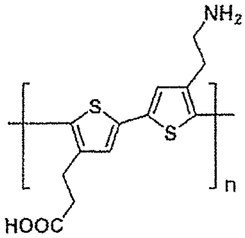

(49)
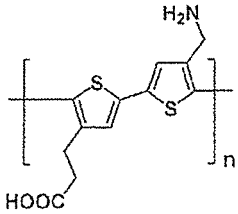

(50)
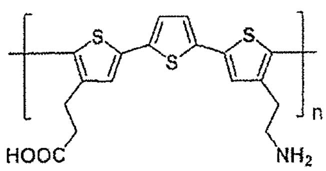

(51)

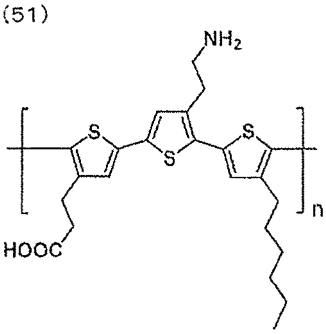

(52)

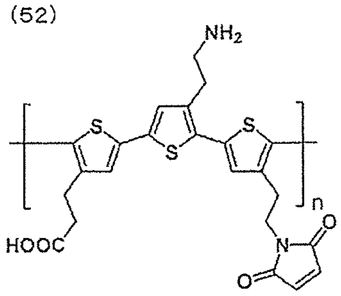

(53)

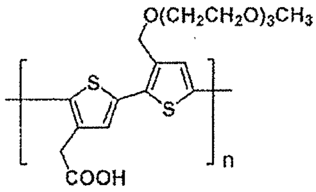

(54)

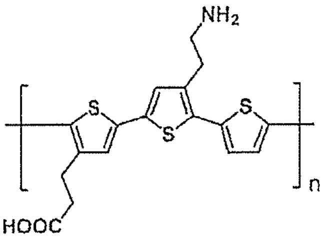

[Chem. 5]

(55)

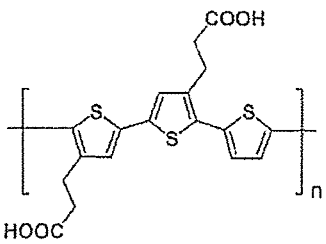

(56)

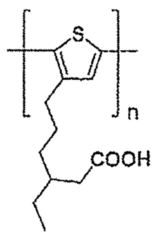

(57)

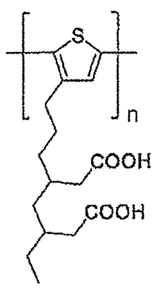

(58)

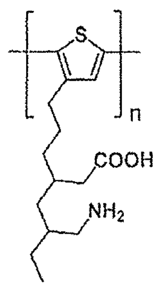

(59)

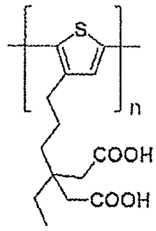

(60)

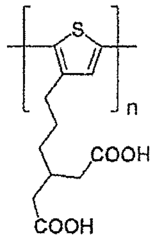

(61)

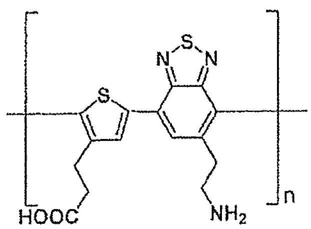

(62)

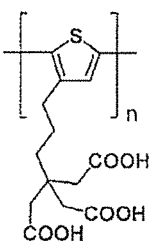

(63)

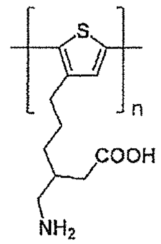

(64)

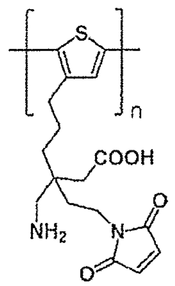

(65)

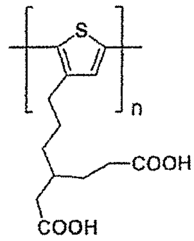

(66)

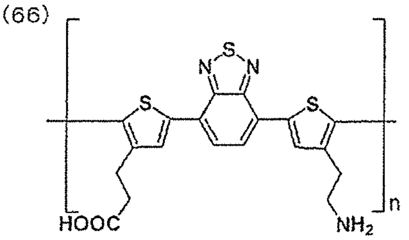

(67)

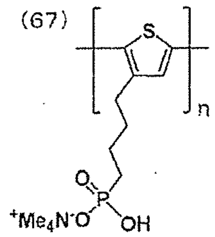

(68)

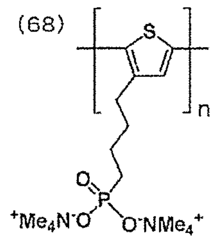

The conjugated polymer for use in the present invention can be synthesized by a known method. When a monomer is synthesized, as the method for linking, for example, thiophene to a thiophene derivative having introduced into the side chain thereof an alkyl group having a carboxy group at the terminal, examples thereof include a method of coupling a halogenated thiophene derivative and a thiopheneboronic acid or a thiopheneboronic acid ester in the presence of a palladium catalyst, and a method of coupling a halogenated thiophene derivative and a thiophene Grignard reagent in the presence of a nickel or palladium catalyst. In addition, coupling when linking another unit having introduced thereinto a functional group to thiophene can also be performed by the same method using a halogenated unit. Furthermore, a polymerizable substituent is introduced into the terminal of the monomer synthesized above, and polymerization is allowed to proceed in the presence of a palladium catalyst or a nickel catalyst, whereby the conjugated polymer can be obtained.

In the conjugated polymer for use in the present invention, impurities such as raw material used in the process of synthesis and byproduct, are preferably removed, and, for example, a silica gel column graphy method, a Soxhlet extraction method, a filtration method, an ion exchange method, and a chelate method can be used therefor. Two or more kinds of these methods may be combined.

(CNT)

Any of single-walled CNT in which one carbon film (graphene sheet) is cylindrically wound, double-walled CNT in which two graphene sheets are concentrically wound, and multi-walled CNT in which a plurality of graphene sheets are concentrically wound, may be used as CNT, but in order to obtain high semiconductor properties, it is preferable to use a single-walled CNT. CNT can be obtained by an arc discharge method, a chemical vapor deposition method (CVD method), a laser abrasion method, etc.

More preferably, CNT contains 80 wt% or more of semiconducting CNT. It is still more preferable to contain 95 wt% or more of a semiconducting CNT. As the method for obtaining semiconducting CNT in a ratio of 80 wt% or more, a conventional method may be used. Examples thereof include a method of performing ultracentrifugation in the coexistence of a density gradient agent, a method of attaching a specific compound selectively to the surface of semiconducting or metallic CNT and achieving separation utilizing the difference in the solubility, and a method of achieving separation by electrophoresis, etc. utilizing the difference in the electrical property. As the method for measuring the content percentage of semiconducting CNT, examples thereof include, for example, a method of calculating the content percentage from the absorption area ratio of the visible-near infrared absorption spectrum, and a method of calculating the content percentage from the intensity ratio of the Raman spectrum.

In the present invention, the length of CNT is preferably shorter than the distance between a first electrode and a second electrode in a semiconductor device or sensor to which it is applied. Specifically, the average length of CNT is preferably 2 μm or less, more preferably 1 μm or less, although this varies depending on the channel length. The average length of CNT indicates an average value of lengths of randomly picked-up 20 CNTs. As the method for measuring the average length of CNT, examples thereof include a method of randomly picking up 20 CNTs from an

image obtained by means of an atomic force microscope, a scanning electron microscope, a transmission electron microscope, etc. and determining an average value of the lengths thereof.

Commercially available CNT generally has a length distribution and sometimes contains CNT longer than the distance between electrodes and therefore, it is preferable to add a step of making CNT shorter than the distance between electrodes. For example, a method of cutting the carbon nanotube into a short fiber by an acid treatment with nitric acid, sulfuric acid, etc., an ultrasonic treatment, or freeze grinding is effective. In addition, using separation through a filter in combination is more preferred from the standpoint of enhancing the purity.

The diameter of CNT is not particularly limited but is preferably 1 nm or more and 100 nm or less, more preferably 50 nm or less.

In the present invention, it is preferable to provide a step of uniformly dispersing CNT in a solvent and filtering the dispersion liquid through a filter. By obtaining CNT smaller than the pore size of the filter, CNT shorter than the distance between electrodes is effectively obtained. In this case, as the filter, a membrane filter is preferably used. The pore size of the filter to be used for filtration may be sufficient if it is smaller than the channel length, and the pore size is preferably from 0.5 to 10 μm.

As the other methods for shortening CNT, examples thereof include an acid treatment, a freeze grinding treatment, etc.

(Semiconductor Device)

The semiconductor device containing the CNT composite in the present invention is described below. The semiconductor device in the present invention includes a substrate, a first electrode, a second electrode, and a semiconductor layer, in which the first electrode is disposed with spacing from the second electrode, the semiconductor layer is disposed between the first electrode and the second electrode, and the semiconductor layer contains the CNT composite in the present invention. In another embodiment, the semiconductor device further includes a third electrode and an insulating layer, in which the third electrode is disposed to be electrically insulated from the first electrode, the second electrode and the semiconductor layer by the insulating layer.

FIGs. 1 and 2 are schematic cross-sectional views each showing an example of the semiconductor device in the present invention. In the semiconductor device of FIG. 1, a first electrode 2 and a second electrode 3 are formed on a substrate 1, and a semiconductor layer 4 is disposed between the first electrode 2 and the second electrode 3. In the semiconductor device of FIG. 2, a third electrode 5 and an insulating layer 6 are formed on a substrate 1, a first electrode 2 and a second electrode 3 are formed thereon, and a semiconductor layer 4 containing the CNT composite in the present invention is disposed between the first electrode 2 and the second electrode 3. The semiconductor device of FIG. 2 has a function as FET, in which the first electrode 2, second electrode 3 and third electrode 5 correspond to a source electrode, a drain electrode and a gate electrode, respectively, and the insulating layer 6 corresponds to a gate insulating layer.

As the material to be used for the substrate 1, examples thereof include, for example, an inorganic material such as silicon wafer, glass and alumina sintered body, and an organic material such as polyimide, polyester, polycarbonate, polysulfone, polyethersulfone, polyethylene, polyphenylene sulfide and poly-para-xylene.

As the material to be used for the first electrode 2, the second electrode 3 and the third electrode 5, examples thereof include, for example, an electrically conductive metal oxide such as tin oxide, indium oxide, and indium tin oxide (ITO); a metal such as platinum, gold, silver, copper, iron, tin, zinc, aluminum, indium, chromium, lithium, sodium, potassium, cesium, calcium, magnesium, palladium, molybdenum, amorphous silicon and polysilicon, or an alloy thereof; an inorganic electrically conductive substance such as copper iodide and copper sulfide; an organic electrically conductive substance such as polythiophene, polypyrrole, polyaniline and a complex of polyethylenedioxythiophene and polystyrenesulfonic acid; and a nanocarbon material such as carbon nanotube and graphene, but the present invention is not limited thereto. These electrode materials may be used individually, or a plurality of materials may be stacked or mixed and used. In the case of use as a sensor, from the standpoint of stability in an aqueous solution, etc. with which the electrode comes into contact, the material for the first electrode 2 and the second electrode 3 is preferably selected from gold, platinum, palladium, an organic electrically conductive substance, and a nanocarbon material.

As the material of the insulating layer 6, usable examples thereof include an inorganic material such as silicon oxide and alumina, an organic polymer material such as polyimide, polyvinyl alcohol, polyvinyl chloride, polyethylene terephthalate, polyvinylidene fluoride, polysiloxane and polyvinyl phenol (PVP), or a mixture of an inorganic material powder and an organic polymer material.

The film thickness of the insulating layer 6 is preferably 10 nm or more and 5 μm or less, more preferably 50 nm or more and 3 μm or less, still more preferably 100 nm or more and 1 μm or less. The film thickness can be measured by an atomic force microscope, an ellipsometry, etc.

The semiconductor layer 4 contains the CNT composite in the present invention. The semiconductor layer 4 may further contain an organic semiconductor or an insulating material, as long as the electrical properties of the CNT

composite are not impaired.

The film thickness of the semiconductor layer 4 is preferably 1 nm or more and 100 nm or less. Within this range, the change in electrical properties due to an interaction with a sensing target substance can be sufficiently extracted as an electrical signal. The film thickness is more preferably 1 nm or more and 50 nm or less, still more preferably 1 nm or more and 20 nm or less.

As the method for forming the semiconductor layer 4, a dry method such as resistance heating deposition, electron beam, sputtering and CVD may be used, but in view of the production cost and adaptability to a large area, it is preferable to use a coating method. Specifically, a spin coating method, a blade coating method, a slit die coating method, a screen printing method, a bar coater method, a template method, a printing transfer method, a dipping pulling-up method, an inkjet method, etc. may be preferably used. The coating method may be selected according to the coating film properties to be obtained, such as coating film thickness control and orientation control. In addition, the formed coating film may be subjected to an annealing treatment under atmospheric pressure, under reduced pressure or in an inert gas atmosphere (in a nitrogen or argon atmosphere).

In FET, the current flowing between the source electrode and the drain electrode can be controlled by changing the gate voltage. The mobility of FET can be calculated using the following formula (a):

$$\mu=(\delta Id/\delta Vg)L\cdot D/(W\cdot\varepsilon_r\cdot\varepsilon\cdot Vsd) \qquad (a)$$

wherein Id is a current between source and drain, Vsd is a voltage between source and drain, Vg is a gate voltage, D is a thickness of insulating layer, L is a channel length, W is a channel width, $\varepsilon_r$ is relative dielectric constant of gate insulating layer, and $\varepsilon$ is dielectric constant in vacuum ($8.85\times10^{-12}$ F/m).

In addition, an on-off ratio can be determined from the ratio between maximum value of Id and minimum value of Id.

(Sensor)

A sensor including the semiconductor device in the present invention is described below. This sensor contains, in the semiconductor layer, a substance capable of selectively interacting with a sensing target substance.

The sensor including a semiconductor device fabricated as in FIG. 1 experiences a change in the current value flowing between the first electrode and the second electrode or in the electrical resistance value when a sensing target substance or a solution, gas or solid containing it is disposed in the vicinity of the semiconductor layer 4. The sensing target substance can be detected by measuring the change.

The sensor including a semiconductor device fabricated as in FIG. 2 also experiences a change in the current value flowing between the first electrode 2 and the second electrode 3, i.e., in the semiconductor layer 4, when a sensing target substance or a solution, gas or solid containing it is disposed in the vicinity of the semiconductor layer 4. The sensing target substance can be detected by measuring the change.

In addition, in the sensor including the semiconductor device of FIG. 2, the current value in the semiconductor layer 4 can be controlled by the voltage of the third electrode 5. Accordingly, when the current value flowing between the first electrode 2 and the second electrode 3 is measured by changing the voltage of the third electrode 5, a two-dimensional graph (I-V graph) is obtained.

The sensing target substance may be detected using a part or all of the characteristic values, or the sensing target substance may be detected using the ratio between maximum current and minimum current, i.e., the on-off ratio. Furthermore, conventional electrical properties obtained from the semiconductor device, such as resistance value, impedance, transconductance and capacitance, may also be used.

The sensing target substance may be used by itself or may be mixed with another substance or a solvent. The sensing target substance or a solution, gas or solid containing it is disposed in the vicinity of the semiconductor layer 4. The semiconductor layer 4 interacts with the sensing target substance as described above, and as a result, a change occurs in the electrical properties of the semiconductor layer 4, and this is detected as a change in any of the electrical signals above.

(Bio-Related Material)

The sensor in the present invention contains a bio-related material capable of selectively interacting with the sensing target substance, and the bio-related material is preferably fixed to the semiconductor layer containing the CNT composite. The bio-related material is not particularly limited as long as it can selectively interact with the sensing target substance, and an arbitrary substance can be used. Specific examples thereof include, for example, enzyme, antigen,

antibody, hapten, anti-hapten, peptide, oligopeptide, polypeptide (protein), hormone, nucleic acid, oligonucleotide, biotin, biotinated protein, avidin, streptavidin, saccharides such as sugar, oligosaccharide and polysaccharide, a low molecular compound, a high molecular compound, an inorganic substance and a composite thereof, virus, bacterium, cell, body tissue, and a substance constituting these substances.

The method for fixing the bio-related material to the semiconductor layer is not particularly limited, but it is preferable to utilize a reaction or interaction of the bio-related material with a functional group contained in the CNT composite, i.e., at least one functional group selected from the group consisting of a hydroxyl group, a carboxy group, an amino group, a mercapto group, a sulfo group, a phosphonic acid group, an organic or inorganic salt thereof, a formyl group, a maleimide group and a succinimide group. For example, in the case where an amino group is contained in the bio-related material, a carboxy group, an aldehyde group, and a succinimide group are exemplified, and in the case of a thiol group, a maleimide group, etc. are exemplified.

Among the functional groups above, a carboxy group and an amino group facilitate utilization of a reaction or interaction with the bio-related material and make it easy to fix the bio-related material to the semiconductor layer. For this reason, the functional group contained in at least a part of the CNT composite is preferably a carboxy group or an amino group.

Specific examples of the reaction or interaction include chemical bonding, hydrogen bonding, ionic bonding, coordination bonding, electrostatic force, and van der Waals force, but the reaction or interaction is not particularly limited thereto and may be appropriately selected according to the kind of the functional group and the chemical structure of the bio-related material. If desired, the bio-related material may be fixed after a part of the functional group and/or bio-related material is converted to another appropriate functional group. In addition, a linker such as terephthalic acid may also be applied between the functional group and the bio-related material.

The process for the fixing is not particularly limited, but examples thereof include, for example, a process of adding dropwise a bio-related material-containing solution onto a CNT composite-containing semiconductor layer, fixing the bio-related material while applying, if desired, heating, cooling, vibration, etc., and then removing surplus components by washing or drying.

The sensing target substance detected by the sensor in the present invention is not particularly limited, but examples thereof include, for example, enzyme, antigen, antibody, hapten, peptide, oligopeptide, polypeptide (protein), hormone, nucleic acid, oligonucleotide, saccharides such as sugar, oligosaccharide and polysaccharide, a low molecular compound, an inorganic substance and a composite thereof, virus, bacterium, cell, body tissue, and a substance constituting these substances. Such a target substance reacts or interacts either with at least one member selected from the group consisting of a hydroxyl group, a carboxy group, an amino group, a mercapto group, a sulfo group, a phosphonic acid group, an organic or inorganic salt thereof, a formyl group, a maleimide group and a succinimide group, or with the bio-related material, thereby bringing about a change in the electrical properties of the semiconductor layer in the sensor of the present invention.

The low molecular compound is not particularly limited, but examples thereof include, for example, a compound generated from a living body, the compound including a gas at ordinary temperature and ordinary pressure, such as ammonia and methane, and a solid compound such as uric acid.

In the sensor in the present invention, the combination of functional group contained in CNT composite/bio-related material/sensing target substance includes, for example, carboxy group/glucose oxidase/β-D-glucose, carboxy group/T-PSA-mAb (monoclonal antibody for prostate-specific antigen)/PSA (protate-specific antigen), carboxy group/hCG-mAb (anti-human chorionic gonadotropin)/hCG (human chorionic gonadotropin), carboxy group/artificial oligonucleotides/IgE (immunoglobulin E), carboxy group/diisopropylcarbodiimide/IgE, carboxy group/amino group-terminated RNA/HIV-1 (human immunodeficiency virus), carboxy group/natriuretic peptide receptor/BNP (brain natriuretic peptide), amino group/RNA/HIV-1, amino group/biotin/avidin, mercapto group/T-PSA-mAb/PSA, mercapto group/hCG-mAb/hCG, sulfo group/T-PSA-mAb/PSA, sulfo group/hCG-mAb/hCG, phosphonic acid group/T-PSA-mAb/PSA, phosphonic acid group/hCG-mAb/hCG, aldehyde group/oligonucleotide/nucleic acid, aldehyde group/anti-AFP polyclonal antibody (antibody for immunostaining of human tissue)/α fetoprotein, maleimide group/cystine, succinimide ester/streptavidin/biotin, and sodium carboxylate/glucose oxidase/β-D-glucose. In addition, in the case where the bio-related material contains a functional group, a combination of functional group-containing compound (=bio-related material)/sensing target substance may also be preferably used, and specifically, as the combination thereof, examples thereof include IgE aptamer/IgE, biotin/avidin, streptavidin/biotin, natriuretic peptide receptor/BNP (brain natriuretic peptide), etc.

(Method for Manufacturing Sensor)

The method for manufacturing a sensor containing the semiconductor device shown in FIG. 1] is described. The method for manufacturing this sensor includes a step of applying a CNT composite onto a substrate and drying the coating to form a semiconductor layer. The manufacturing method is not limited to the following.

First of all, a first electrode 2 and a second electrode 3 are formed on a substrate 1. Examples of the method for fonning the electrode include, for example, a known method such as metal vapor deposition, spin coating method, blade coating method, slit die coating method, screen printing method, bar coater method, template method, printing transfer method, dipping pulling-up method and inkjet method. A pattern may be directly formed using a mask, etc. or after applying a resist onto a substrate, the resist film may be exposed/developed in a desired pattern and then etched, thereby patterning a gate electrode.

Next, a semiconductor layer 4 is formed by the above-described method for forming the layer, and a bio-related material capable of selectively interacting with a sensing target substance is fixed to the semiconductor layer by the method described above.

Here, the formation of a semiconductor layer and fixing of a bio-related material may be performed separately or may be performed en bloc. In the case of performing the formation and fixing en bloc, examples of the method therefor include, for example, a method of forming a semiconductor layer by using a CNT composite into which a bio-related material is previously incorporated.

The method for manufacturing a sensor containing the semiconductor device shown in FIG. 2 is a method where a step of first forming a third electrode 5 and an insulating layer 6 on a substrate 1 is added to the method for manufacturing a sensor containing the semiconductor device shown in FIG. 1.

The sensor in the present invention can be utilized in a thin-film field-effect transistor, a switching element, and various sensors such as gas sensor, ion sensor, enzyme sensor, immunosensor, DNA sensor, cardiac marker and hormone sensor. For example, in the case of an enzyme sensor, as the combination of functional group contained in sensor/bio-related material/sensing target substance, examples thereof include carboxy group/glucose oxidase/β-D-glucose, etc. In the case of a cardiac marker, examples thereof include carboxy group/natriuretic peptide receptor/BNP (brain natriuretic peptide), etc.

EXAMPLES

The present invention is described in greater detail below based on Examples. The present invention is not limited to the following Examples. Here, CNTs used are as follows.

CNT1: produced by CNI, single-walled CNT, purity: 95%
CNT2: produced by Meijo Nano Carbon Co., Ltd., single-walled CNT, purity: 95%

Of compounds used, those indicated by abbreviations are as follows.

NMP: N-methylpyrrolidone
PBS: phosphate buffered saline
BSA: bovine serum albumin
IgE: immunogloblin E
THF: tetrahydrofuran
o-DCB: o-dichlorobenzene
DMF: dimethylformamide
DMSO: dimethylsulfoxide
SDS: sodium dodecylsulfate

Example 1:

(1) Synthesis of Conjugated Polymer (19)

6.48 g of iron(III) chloride was dissolved in 30 ml of chloroform, and a chloroform solution (20 ml) containing 1.56 g of 3-thiophenemethyl acetate was added dropwise thereto while stirring under a nitrogen stream. The resulting solution was cooled to 0°C and after stirring for 24 hours, it was poured in 1 1 of methanol. The precipitate was collected and washed with methanol and pure water, and 0.5 g of the solid obtained was added to 50 ml of an aqueous 2.0 M sodium hydroxide solution, followed by stirring at 100°C for 24 hours. A precipitate resulting from neutralization by the addition of diluted hydrochloric acid was washed with pure water and vacuum-dried at room temperature for 24 hours to obtain Conjugated Polymer (19).

(2) Preparation of Semiconductor Solution

1.5 mg of CNT1 and 1.5 mg of Conjugated Polymer (19) were added to 15 ml of NMP, and the mixture was

ultrasonically stirred at an output of 250 W for 30 minutes by using an ultrasonic homogenizer (VCX-500, manufactured by Tokyo Rikakikai Co., Ltd.) while cooling on ice to obtain CNT Dispersion Liquid A (concentration of CNT composite relative to solvent: 0.1 g/l).

Next, a semiconductor solution for forming a semiconductor layer was prepared. CNT Dispersion Liquid A was filtered using a membrane filter (pore size: 10 μm, diameter: 25 mm, Omnipore Membrane produced by Millipore) to remove CNT composites having a length of 10 μm or more. To 5 ml of the filtrate obtained, 45 ml of NMP was added to make Semiconductor Solution A (concentration of CNT composite relative to solvent: 0.01 g/l).

(3) Preparation of Polymer Solution for Insulating Layer

61.29 g (0.45 mol) of methyltrimethoxysilane, 12.31 g (0.05 mol) of β-(3,4-epoxycyclohexyl)ethyltrimethoxysilane, and 99.15 g (0.5 mol) of phenyltrimethoxysilane were dissolved in 203.36 g of propylene glycol monobutyl ether (boiling point: 170°C), and 54.90 g of water and 0.864 g of phosphoric acid were added thereto while stirring. The resulting solution was heated at a bath temperature of 105°C for 2 hours, and the internal temperature was raised to 90°C to distill off mainly a component composed of methanol produced as a byproduct. The heating was conducted at a bath temperature of 130°C for 2.0 hours and after distilling off mainly a component composed of water and propylene glycol monobutyl ether by raising the internal temperature to 118°C, it was cooled to room temperature to obtain Polymer Solution A having a solid content concentration of 26.0 wt%.

50 g of Polymer Solution A was weighed and mixed with 16.6 g of propylene glycol monobutyl ether (boiling point: 170°C), and the mixture was stirred at room temperature for 2 hours to obtain Polymer Solution B (solid content concentration: 19.5 wt%).

(4) Manufacture of Semiconductor Device

A semiconductor device shown in FIG. 2 was manufactured. Chromium of 5 nn and gold of 50 nm were vacuum-deposited on a grass-made substrate 1 (film thickness: 0.7 mm) through a mask by a resistance heating method to form a third electrode 5. Next, Polymer Solution B prepared by the method described in (3) above was applied by spin coating (800 rpmx20 seconds) onto the grass substrate having formed thereon the third electrode and heat-treated at 120°C for 5 minutes, and then, Insulating Material Solution A was again applied by spin coating (800 rpm×20 seconds) and heat-treated at 200°C for 30 minutes under a nitrogen stream to form an insulating layer 6 having a film thickness of 400 nm. Thereafter, gold was vacuum-deposited to give a film thickness of 50 nm by a resistance heating method, and a photoresist (trade name: "LC100-10cP" produced by Rohm and Haas Co.) was applied thereonto by spin coating (1000 rpmx20 seconds), followed by heating and drying at 100°C for 10 minutes.

The produced photoresist film was patternwise exposed through a mask by using a parallel light mask aligner (PLA-501F manufactured by Canon Inc.), shower-developed for 70 seconds with ELM-D (trade name, produced by Mitsubishi Gas Chemical Company, Inc.) as an aqueous 2.38 wt% tetramethylammonium hydroxide solution by using an automatic processor (AD-2000, manufactured by Takizawa Co., Ltd.), then washed with water for 30 seconds, subjected to an etching treatment for 5 minutes with AURUM-302 (trade name, produced by Kanto Chemical Co., Inc.), and again washed with water for 30 seconds. Thereafter, it was dipped in AZ Remover 100 (trade name, produced by AZ Electronic Materials) for 5 minutes to remove the resist, washed with water for 30 seconds, followed by heating and drying at 120°C for 20 minutes to form a first electrode 2 and a second electrode 3.

The width of each of these two electrodes (channel width) was 100 μm, and the distance between two electrodes (channel length) was 10 μm. Onto the substrate having formed thereon the electrodes, 400 pl of Semiconductor Solution A prepared by the method described in (2) above was added dropwise by using an inkjet apparatus (manufactured by Cluster Technology Co., Ltd.) to form a semiconductor layer 4, and the layer was heat-treated on a hot plate at 150°C for 30 minutes under a nitrogen stream to obtain a semiconductor device.

Subsequently, the characteristics of (current (Id) between first electrode 2 and second electrode 3 - voltage (Vsd) between first electrode 2 and second electrode 3) were measured by changing the voltage (Vg) of the third electrode 5 of the semiconductor device obtained above. A semiconductor property assessment system, Model 4200-SCS (manufactured by Keithley Instruments Inc.) was used for the measurement, and the characteristics were measured in the air (temperature: 20°C, humidity: 35%). The mobility in a linear region was determined from the change in the Id value at Vsd = -1V when changing Vg from +10V to -10V and found to be 0.35 $cm^2$/V·sec. In addition, the on-off ratio when changing Vg from +10V to -10V was 2.5E+6.

(5) Evaluation as Sensor

The semiconductor device manufactured above was placed in a measuring box capable of adjusting the atmosphere so as to evaluate it as a sensor. First, FET characteristics were measured in the air (temperature: 20°C,

humidity: 35%), and as a result, the mobility was 0.35 $cm^2/V \cdot sec$, and the on-off ratio was 2.5E+6. Next, an ammonia gas was introduced into the box to have a concentration of 20 ppm, and after a standstill for 5 minutes, the characteristics of the semiconductor device were measured, and as a result, the mobility and the on-off ratio were greatly changed to 0.23 $cm^2/V \cdot sec$ and 1.7E+6, respectively, revealing that the semiconductor device functions as a sensor.

Example 2:

A sensor in another embodiment was manufactured in the same manner as in Example 1 except that the third electrode 5 and the insulating layer 6 were not formed. The sensor was placed in a measuring box capable of adjusting the atmosphere, and first, the current value flowing between the first electrode 2 and the second electrode 3 was measured in the air and found to be 1.2 μA. Next, an ammonia gas was introduced into the box to have a concentration of 20 ppm, and after a standstill for 5 minutes, the current value was measured, and as a result, the value was greatly changed to 0.7 μA, revealing that the semiconductor device functions as a sensor.

Example 3:

A semiconductor device was manufactured in the same manner as in Example 1 except that CNT2 was used in place of CNT1. Next, the semiconductor layer 4 of the manufactured semiconductor device was dipped in 100 μl of 0.01 M PBS (pH: 7.2, produced by Wako Pure Chemical Industries, Ltd.), and the current value flowing between the first electrode 2 and the second electrode 3 was measured. The measurement was performed at a voltage (Vsd) between first electrode and second electrode of -0.2 V in the air (temperature: 20°C, humidity: 35%). To the 0.01 M PBS having dipped in the semiconductor layer 4, 20 μl of a 0.01 M PBS solution of streptavidin (produced by Wako Pure Chemical Industries, Ltd.) was added 2 minutes after the start of measurement, 20 μl of a 0.01 M PBS solution of BSA (produced by Aldrich) was added 7 minutes after the start of measurement, and 20 μl of a 0.01 M PBS solution of IgE (produced by Yamasa Corporation) was added 12 minutes after the start of measurement. FIG. 3 shows the results. The current value was greatly changed by the addition of streptavidin, BSA and IgE, and the semiconductor device was confirmed to function as a sensor.

Example 4:

(1) Synthesis of Conjugated Polymer (30)

81.6 mg of 3-thiopheneacetic acid (produced by Wako Pure Chemical Industries, Ltd.) and 93.6 mg of 3-hexylthiophene (produced by Tokyo Chemical Industry Co., Ltd.) were dissolved in 7 ml of chloroform (produced by Wako Pure Chemical Industries, Ltd.), and a nitromethane (produced by Wako Pure Chemical Industries, Ltd.) solution (6 ml) containing 0.92 g of iron(III) chloride (produced by Wako Pure Chemical Industries, Ltd.) was added dropwise thereto while stirring under a nitrogen stream. After stirring at room temperature for 3 hours, 20 ml of methanol (produced by Wako Pure Chemical Industries, Ltd.) was poured thereinto. The precipitate was collected and washed with methanol, and the solid obtained was vacuum-dried at 60°C for 2 hours to obtain the conjugated polymer above.

(2) Preparation of Semiconductor Solution

1.0 mg of CNT2 was added to a THF (produced by Wako Pure Chemical Industries, Ltd.) solution (10 ml) containing 2.0 mg of the conjugated polymer obtained above, and the mixture was ultrasonically stirred at an output of 20% for 4 hours by using an ultrasonic homogenizer (VCX-500, manufactured by Tokyo Rikakikai Co., Ltd.) while cooling on ice to obtain CNT Dispersion Liquid B (concentration of CNT composite relative to solvent: 0.1 g/l).

Next, a semiconductor solution for forming a semiconductor layer was prepared. CNT Dispersion Liquid A was filtered using a membrane filter (pore size: 10 μm, diameter: 25 mm, Omnipore Membrane produced by Millipore) to remove CNT composites having a length of 10 μm or more. To 1 ml of the filtrate obtained, 3 ml of THF was added to make Semiconductor Solution B (concentration of CNT composite relative to solvent: 0.03 g/l).

(3) Manufacture of Semiconductor Device

A semiconductor layer 4 was formed in the same manner as in Example 1 (4) except that Semiconductor Solution B was used in place of Semiconductor Solution A. Then, 6.3 mg of N-hydroxysuccinimide (produced by Wako Pure Chemical Industries, Ltd.) was dissolved in 10 mL of THF to obtain THF Solution A. Subsequently, 0.1 mL of N,N'-diisopropylcarbodiimide (produced by Wako Pure Chemical Industries, Ltd.) was dissolved in 5 mL of THF, and a 0.6 mL portion of the resulting solution was added to THF Solution A to obtain THF Solution B. The semiconductor layer 4

was dipped in THF Solution B for 1 hour. Thereafter, the semiconductor layer 4 was thoroughly rinsed with THF and pure water and then dipped in a PBS solution of 12 μL/mg IgE aptamer (D17.4EXT produced by FASMAC Co., Ltd.) overnight. The semiconductor layer 4 was then thoroughly rinsed with PBS and pure water to obtain a semiconductor device in which an IgE aptamer was fixed to the semiconductor layer 4.

(4) Evaluation as Sensor

The semiconductor device manufactured above was measured in the same manner as in Example 3 so as to evaluate it as a sensor. To the 0.01 M PBS having dipped in the semiconductor layer 4, 20 μl of a 0.01 M PBS solution of streptavidin was added 4 minutes after the start of measurement, 20 μl of a 0.01 M PBS solution of BSA was added 9 minutes after the start of measurement, and 20 μl of a 0.01 M PBS solution of IgE was added 14 minutes after the start of measurement. FIG. 4 shows the results. The current value was greatly changed only at the time of addition of IgE, and the semiconductor device was confirmed to function as a sensor capable of specifically detecting IgE.

Example 5:

(1) Synthesis of Conjugated Polymer (4)

10.3 g of 3-bromothiophene (produced by Tokyo Chemical Industry Co., Ltd.) was dissolved in 160 mL of hexane (produced by Wako Pure Chemical Industries, Ltd.), and 43.3 mL of n-butyllithium (produced by Tokyo Chemical Industry Co., Ltd.) was added dropwise thereto while stirring at -40°C under a nitrogen stream. After 10 minutes, 10 mL of THF was added, followed by stirring for 1 hour, and the temperature was then raised to -10°C. Subsequently, 20.9 mL of dibromobutane (produced by Tokyo Chemical Industry Co., Ltd.) was added dropwise while stirring, and the temperature was then raised to room temperature. The mixture was stirred for 2 hours and after adding 100 mL of water, it was extracted with diethyl ether (produced by Wako Pure Chemical Industries, Ltd.). The extract was dried over magnesium sulfate (produced by Wako Pure Chemical Industries, Ltd.) and after distilling off the solvent, it was purified by silica gel column chromatography. By distilling off the solvent, 8.5 g of 3-(2-bromobutyl)thiophene was obtained.

Next, 8.0 g of 3-(2-bromobutyl)thiophene obtained above was dissolved in 100 mL of THF, and 1 mL of acetic acid (produced by Wako Pure Chemical Industries, Ltd.) and 14.9 g of n-bromosuccinimide (produced by Wako Pure Chemical Industries, Ltd.) were added thereto. The mixture was stirred at room temperature for 1 hour and after adding 60 mL of water, it was extracted with diethyl ether (produced by Wako Pure Chemical Industries, Ltd.), and the extract was washed with an aqueous sodium hydrogen carbonate solution and dried over magnesium sulfate. The solvent was then distilled off, and it was purified by silica gel column chromatography. After distilling off the solvent, the obtained solid was vacuum-dried at 60°C for 2 hours to obtain 14.1 g of 2,5-dibromo-3-(2-bromobutyl)thiophene.

Subsequently, 4.09 g of 2,5-dibromo-3-(2-bromobutyl)thiophene obtained above was dissolved in 80 mL of THF, and 12 mL of methylmagnesium bromide (produced by Tokyo Chemical Industry Co., Ltd.) was added dropwise thereto while stirring under a nitrogen steam. The mixture was stirred at 80°C for 2 hours, and 30 mg of dichloro[1,3-bis(diphenylphosphino)propane]nickel(II) (produced by Aldrich) was added. After stirring for 1 hour, 80 mL of methanol was added, and the precipitate was collected and washed with methanol. The obtained solid was vacuum-dried at 60°C for 2 hours to obtain 1.1 g of poly(3-(2-bromobutyl)thiophene).

Thereafter, 0.423 g of poly(3-(2-bromobutyl)thiophene) obtained above and 1.21 g of sodium azide (produced by Tokyo Chemical Industry Co., Ltd.) were dissolved in 100 mL of DMF (produced by Wako Pure Chemical Industries, Ltd.) and after stirring at 120°C for 12 hours, 70 mL of methanol was added. The precipitate was collected and washed with methanol, and the obtained solid was vacuum-dried at 60°C for 2 hours to obtain 0.279 g of poly(3-(2-azidobutyl)thiophene).

Furthermore, 0.235 g of poly(3-(2-azidobutyl)thiophene) obtained above was dissolved in 30 mL of THF, and a THF solution (3 mL) containing 0.152 g of lithium aluminum hydride (produced by Tokyo Chemical Industry Co., Ltd.) was added dropwise thereto while stirring at room temperature under a nitrogen stream. After stirring for 30 minutes, 20 mL of 3 M hydrochloric acid was added. The mixture was washed with water, and the obtained solid was vacuum-dried at 60°C for 2 hours to obtain Conjugated Polymer (4).

(2) Preparation of Semiconductor Solution

1.0 mg of CNT2 was added to a THF solution (10 ml) containing 2.0 mg of Conjugated Polymer (4), and the mixture was ultrasonically stirred at an output of 20% for 4 hours by using an ultrasonic homogenizer (VCX-500, manufactured by Tokyo Rikakikai Co., Ltd.) while cooling on ice to obtain CNT Dispersion Liquid C (concentration of CNT composite relative to solvent: 0.89 g/l).

Next, a semiconductor solution for forming a semiconductor layer was prepared. CNT Dispersion Liquid C was

filtered using a membrane filter (pore size: 10 μm, diameter: 25 mm, Omnipore Membrane produced by Millipore) to remove CNT composites having a length of 10 μm or more. To 1 ml of the filtrate obtained, 4 ml of THF was added to make Semiconductor Solution C (concentration of CNT composite relative to solvent: 0.03 g/l).

(3) Manufacture of Semiconductor Device

A semiconductor layer 4 was formed in the same manner as in Example 2 except that Semiconductor Solution C was used in place of Semiconductor Solution A. Thereafter, the semiconductor layer 4 was dipped in a 0.01 M PBS solution (1 mL) containing 0.9 mg of biotin N-hydroxysulfosuccinimide ester (produced by DOJINDO Laboratories) overnight. The semiconductor 4 was then thoroughly rinsed with pure water to obtain a semiconductor device in which biotin was fixed to the semiconductor layer 4.

(4) Evaluation as Sensor

The semiconductor device manufactured above was measured in the same manner as in Example 3 so as to evaluate it as a sensor. To the 0.01 M PBS having dipped in the semiconductor layer 4, 20 μl of a 0.01 M PBS solution of IgE was added 4 minutes after the start of measurement, 20 μl of a 0.01 M PBS solution of BSA was added 9 minutes after the start of measurement, and 20 μl of a 0.01 M PBS solution of avidin was added 14 minutes after the start of measurement. FIG. 5 shows the results. The current value was greatly changed only at the time of addition of avidin, and the semiconductor device was confirmed to function as a sensor capable of specifically detecting avidin.

Example 6:

(1) Preparation of Semiconductor Solution

1.0 mg of CNT1 was added to a chloroform solution (10 ml) containing 2.0 mg of poly(3-hexylthiophene) (P3HT) (produced by Aldrich), and the mixture was ultrasonically stirred at an output of 20% for 4 hours by using an ultrasonic homogenizer (VCX-500, manufactured by Tokyo Rikakikai Co., Ltd.) while cooling on ice to obtain CNT Dispersion Liquid D (concentration of CNT composite relative to solvent: 0.96 g/l).

Next, a semiconductor solution for forming a semiconductor layer was prepared. CNT Dispersion Liquid D was filtered using a membrane filter (pore size: 10 μm, diameter: 25 mm, Omnipore Membrane produced by Millipore) to remove CNT composites having a length of 10 μm or more. After adding 5 ml of o-DCB (produced by Wako Pure Chemical Industries, Ltd.) to the obtained filtrate, chloroform as a low-boiling-point solvent was distilled off using a rotary evaporator, and the solvent was replaced by o-DCB to obtain CNT Dispersion Liquid E. To 1 ml of CNT Dispersion Liquid E, 3 mL of o-DCB was added to make Semiconductor Solution D (concentration of CNT composite relative to solvent: 0.03 g/l).

(2) Manufacture of Semiconductor Device

A semiconductor layer 4 was formed in the same manner as in Example 2 except that Semiconductor Solution D was used in place of Semiconductor Solution A. Then, the semiconductor layer 4 was dipped in a DMF (produced by Wako Pure Chemical Industries, Ltd.) solution (1.0 mL) containing 6.3 mg of pyrenebutanoic acid succinimide ester (produced by AnaSpec, Inc.) for 1 hour. Thereafter, the semiconductor layer 4 was thoroughly rinsed with DMF and DMSO (produced by Wako Pure Chemical Industries, Ltd.). The semiconductor layer 4 was then dipped in a DMSO solution (1.0 mL) containing 10 μL of diethylene glycol bis(3-aminopropyl)ether (produced by Tokyo Chemical Industry Co., Ltd.) overnight. Subsequently, the semiconductor layer 4 was thoroughly rinsed with DMSO and pure water. Furthermore, the semiconductor layer 4 was dipped in a 0.01 M PBS solution (1.0 mL) containing 0.9 mg of biotin N-hydroxysulfosuccinimde ester overnight. The semiconductor layer 4 was then thoroughly rinsed with pure water to obtain a semiconductor device in which biotin was fixed to the semiconductor layer 4.

(3) Evaluation as Sensor

The semiconductor device manufactured above was measured in the same manner as in Example 3 so as to evaluate it as a sensor. To the 0.01 M PBS having dipped in the semiconductor layer 4, 20 μl of a 0.1 M PBS solution of IgE was added 4 minutes after the start of measurement, 20 μl of a 0.1 M PBS solution of BSA was added 9 minutes after the start of measurement, and 20 μl of a 0.1 M PBS solution of avidin was added 14 minutes after the start of measurement. The current value was reduced by 0.04 uA only at the time of addition of avidin, and the semiconductor device was confirmed to function as a sensor capable of specifically detecting avidin.

Example 7:

A semiconductor device was manufactured in the same manner as in Example 6 except that when the semiconductor device was manufactured, stearylamine (produced by Tokyo Chemical Industry Co., Ltd.) was used in place of pyrenebutanoic acid succinimide ester and ethanol (produced by Wako Pure Chemical Industries, Ltd.) was used in place of DMF.

The semiconductor device manufactured above was measured in the same manner as in Example 3 so as to evaluate it as a sensor. To the 0.01 M PBS having dipped in the semiconductor layer 4, 20 μl of a 0.1 M PBS solution of IgE was added 4 minutes after the start of measurement, 20 μl of a 0.1 M PBS solution of BSA was added 9 minutes after the start of measurement, and 20 μl of a 0.1 M PBS solution of avidin was added 14 minutes after the start of measurement. The current value was reduced by 0.05 uA only at the time of addition of avidin, and the semiconductor device was confirmed to function as a sensor capable of specifically detecting avidin.

Example 8:

(1) Manufacture of Semiconductor Device

A semiconductor layer 4 was formed in the same manner as in Example 6. Then, the semiconductor layer 4 was dipped in a 0.01 M PBS solution (1.0 mL) containing 0.9 mg of biotin N-hydroxysulfosuccinimde ester overnight. Thereafter, the semiconductor layer 4 was thoroughly rinsed with pure water to obtain a semiconductor device in which biotin was fixed to the semiconductor layer 4.

(2) Evaluation as Sensor

The semiconductor device manufactured above was measured in the same manner as in Example 3 so as to evaluate it as a sensor. To the 0.01 M PBS having dipped in the semiconductor layer 4, 20 μl of a 0.1 M PBS solution of IgE was added 4 minutes after the start of measurement, 20 μl of a 0.1 M PBS solution of BSA was added 9 minutes after the start of measurement, and 20 μl of a 0.1 M PBS solution of avidin was added 14 minutes after the start of measurement. The current value was reduced by 0.05 uA only at the time of addition of avidin, and the semiconductor device was confirmed to function as a sensor capable of specifically detecting avidin.

Example 9:

(1) Preparation of Semiconductor Solution

1.5 mg of CNT1 and 1.5 mg of SDS were added to 30 ml of water, and the mixture was ultrasonically stirred at an output of 250 W for 3 hours by using an ultrasonic homogenizer (VCX-500, manufactured by Tokyo Rikakikai Co., Ltd.) while cooling on ice to obtain CNT Dispersion Liquid F (concentration of CNT composite relative to solvent: 0.05 g/l). CNT Dispersion Liquid F obtained was centrifuged at 21,000 G for 30 minutes by using a centrifugal separator (CT15E manufactured by Hitachi Koki Co., Ltd.), and 80% of the supernatant was extracted to obtain Semiconductor Solution E.

(2) Manufacture of Semiconductor Device

A semiconductor layer 4 was formed in the same manner as in Example 2 except that Semiconductor Solution E was used in place of Semiconductor Solution A. Then, a semiconductor device in which biotin was fixed to the semiconductor layer 4, was obtained in the same manner as in Example 6 (2).

(3) Evaluation as Sensor

The semiconductor device manufactured above was measured in the same manner as in Example 3 so as to evaluate it as a sensor. To the 0.01 M PBS having dipped in the semiconductor layer 4, 20 μl of a 0.1 M PBS solution of IgE was added 4 minutes after the start of measurement, 20 μl of a 0.1 M PBS solution of BSA was added 9 minutes after the start of measurement, and 20 μl of a 0.1 M PBS solution of avidin was added 14 minutes after the start of measurement. The current value was reduced by 0.02 uA only at the time of addition of avidin, and the semiconductor device was confirmed to function as a sensor capable of specifically detecting avidin.

Comparative Example 1:

(1) Manufacture of Semiconductor Device

A semiconductor layer 4 was formed in the same manner as in Example 2 except that Semiconductor Solution D was used in place of Semiconductor Solution A, whereby a semiconductor device was manufactured.

(2) Evaluation as Sensor

The semiconductor device manufactured above was measured in the same manner as in Example 3 so as to evaluate it as a sensor. To the 0.01 M PBS having dipped in the semiconductor layer 4, 20 μl of a 0.1 M PBS solution of IgE was added 4 minutes after the start of measurement, 20 μl of a 0.1 M PBS solution of BSA was added 9 minutes after the start of measurement, and 20 μl of a 0.1 M PBS solution of avidin was added 14 minutes after the start of measurement. In all cases, a change in the current value could not be confirmed, and the semiconductor device did not function as a sensor.

Comparative Example 2

(1) Preparation of Semiconductor Solution

1 g of CNT1 and 50 mL of chloroform were added and dispersed using an ultrasonic bath for 1 hour. Thereafter, 5 mL of the resulting dispersion liquid was separated, diluted to 100 mL, and further dispersed using an ultrasonic bath for 1 hour to obtain CNT Dispersion Liquid G. CNT Dispersion Liquid G was filtered using a membrane filter (pore size: 10 μm, diameter: 25 mm, Onmipore Membrane produced by Millipore) to remove CNTs having a length of 10 μm or more, thereby obtaining Semiconductor Solution F, but a part of CNTs remained aggregated.

(2) Manufacture of Semiconductor Device

A semiconductor layer 4 was formed in the same manner as in Example 2 except that Semiconductor Solution F was used in place of Semiconductor Solution A, whereby a semiconductor device was manufactured.

(3) Evaluation as Sensor

The semiconductor device manufactured above was measured in the same manner as in Example 3 so as to evaluate it as a sensor, but the current value between the first electrode 2 and the second electrode 3 could not be measured.

[Table 1]

| | Organic Substance | Functional Group | Bio-Related Material | CNT Dispersion Liquid | Semiconductor Solution | Configuration of Device | Sensing Target | Selectivity |
|---|---|---|---|---|---|---|---|---|
| Example 1 | (19) | carboxy group | none | A | A | FIG. 2 | ammonia gas | - |
| Example 2 | (19) | carboxy group | none | A | A | FIG. I | ammonia gas | - |
| Example 3 | (19) | carboxy group | none | A | A | FIG. 2 | streptavidin, BSA, IgE | none |
| Example 4 | (30) | carboxy group | IgE aptamer | B | B | FIG. 2 | streptavidin, BSA, IgE | selective (IgE) |
| Example 5 | (4) | amino group | biotin | C | C | FIG. 1 | IgE, BSA, avidin | selective (avidin) |
| Example 6 | P3HT | succinimide ester | biotin | E | D | FIG. 1 | IgE, BSA, avidin | selective (avidin) |
| Example 7 | P3HT | amino group | biotin | E | D | FIG. 1 | IgE, BSA, avidin | selective (avidin) |
| Example 8 | P3HT | biotin | | E | D | FIG. 1 | IgE, BSA, avidin | selective (avidin) |
| Example 9 | SDS | biotin | | F | E | FIG. 1 | IgE, BSA, avidin | selective (avidin) |
| Comparative Example 1 | P3HT | none | none | E | D | FIG. 1 | IgE, BSA, avidin | none |
| Comparative Example 2 | none | none | none | G | F | FIG. 1 | unmeasurable | |

## INDUSTRIAL APPLICABILITY

The CNT composite, semiconductor device and sensor using the same in the present invention can be applied to a wide variety of sensing such as chemical analysis, physical analysis and bioanalysis and, in particular, is suitably used as a medical sensor or a biosensor.

## DESCRIPTION OF REFERENCE NUMERALS AND SIGNS

1: Substrate
2: First electrode
3: Second electrode
4: Semiconductor layer
5: Third electrode
6: Insulating layer

## Claims

1. A carbon nanotube composite having an organic substance attached to at least a part of a surface thereof, wherein at least one functional group selected from the group consisting of a hydroxyl group, a carboxy group, an amino group, a mercapto group, a sulfo group, a phosphonic acid group, an organic or inorganic salt thereof, a formyl group, a maleimide group and a succinimide group is contained in at least a part of the carbon nanotube composite.

2. The carbon nanotube composite according to claim 1, wherein the functional group is contained in a part of the organic substance.

3. The carbon nanotube composite according to claim 1, wherein another compound different from the organic substance is attached to the surface of the carbon nanotube and the functional group is contained in a part of the compound.

4. The carbon nanotube composite according to any one of claims 1 to 3, wherein the organic substance is a conjugated polymer.

5. The carbon nanotube composite according to claim 1 or 2, wherein the organic substance is a conjugated polymer having a side chain and the functional group is contained in at least a part of the side chain.

6. The carbon nanotube composite according to claim 5, wherein an alkylene group is contained in at least a part of the side chain.

7. A semiconductor device comprising a substrate, a first electrode, a second electrode, and a semiconductor layer, wherein the first electrode is disposed with spacing from the second electrode, the semiconductor layer is disposed between the first electrode and the second electrode, and the semiconductor layer contains the carbon nanotube composite as described in any one of claims 1 to 6.

8. The semiconductor device according to claim 7, further comprising a third electrode and an insulating layer, wherein the third electrode is disposed to be electrically insulated from the first electrode, the second electrode and the semiconductor layer by the insulating layer.

9. A method for manufacturing a semiconductor device, the semiconductor device comprising at least a substrate, a first electrode, a second electrode, and a semiconductor layer, the first electrode being disposed with spacing from the second electrode, and the semiconductor layer being disposed between the first electrode and the second electrode, the method comprising a step of applying the carbon nanotube composite as described in any one of claims 1 to 6 to form the semiconductor layer.

10. A sensor comprising the semiconductor device as described in claim 7 or 8.

**11.** The sensor according to claim 10, comprising a bio-related material capable of selectively interacting with a sensing target substance, wherein the bio-related material is fixed to the semiconductor layer comprising the carbon nanotube composite.

**12.** A method for manufacturing a sensor, the sensor comprising the semiconductor device as described in claim 7 or 8, the method comprising a step of fixing a bio-related material capable of selectively interacting with a sensing target substance, to the semiconductor layer of the semiconductor device as described in claim 7 or 8.

FIG. 1

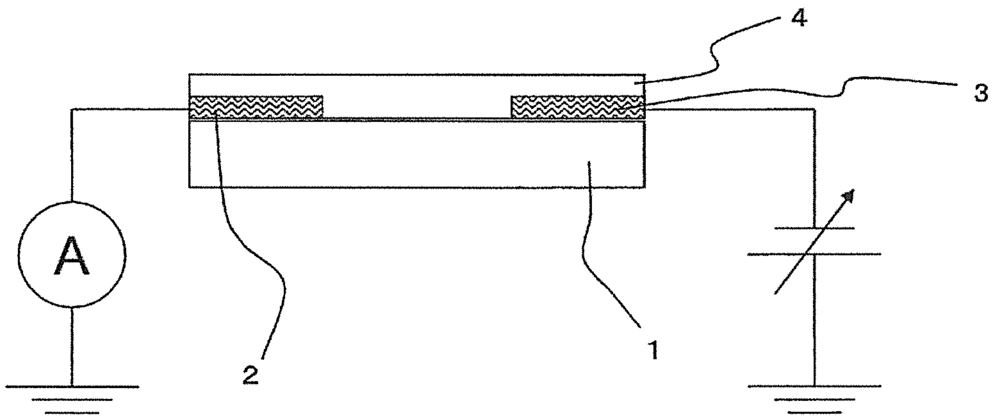


FIG. 2

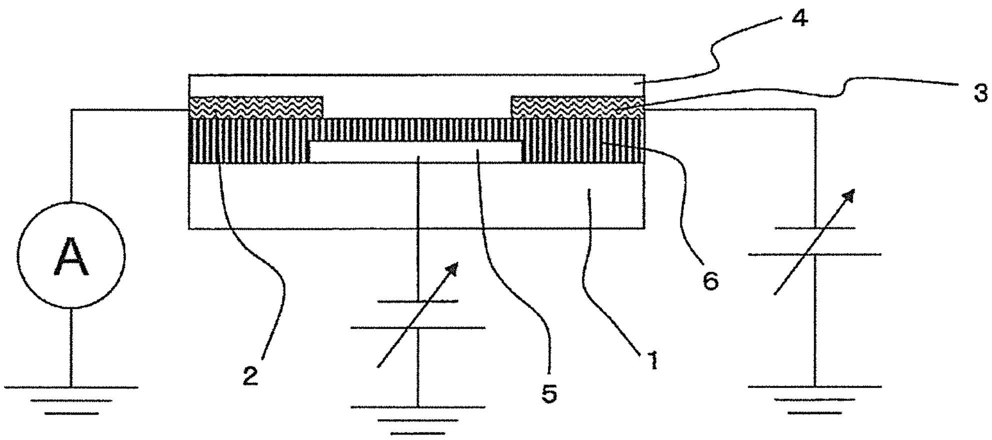

FIG. 3

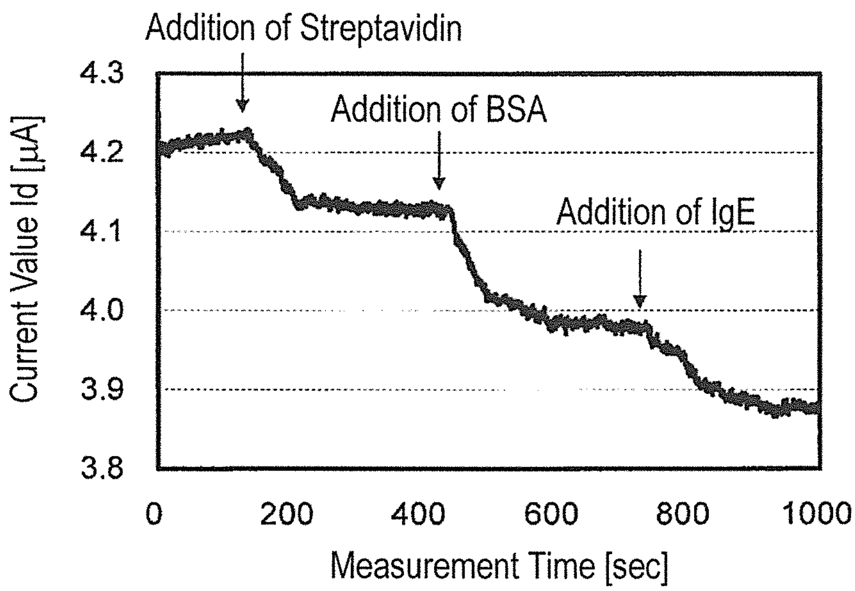
Addition of Streptavidin
Addition of BSA
Addition of IgE
4.3
4.2
4.1
4.0
3.9
3.8
Current Value Id [μA]
0
200
400
600
800
1000
Measurement Time [sec]

FIG. 4

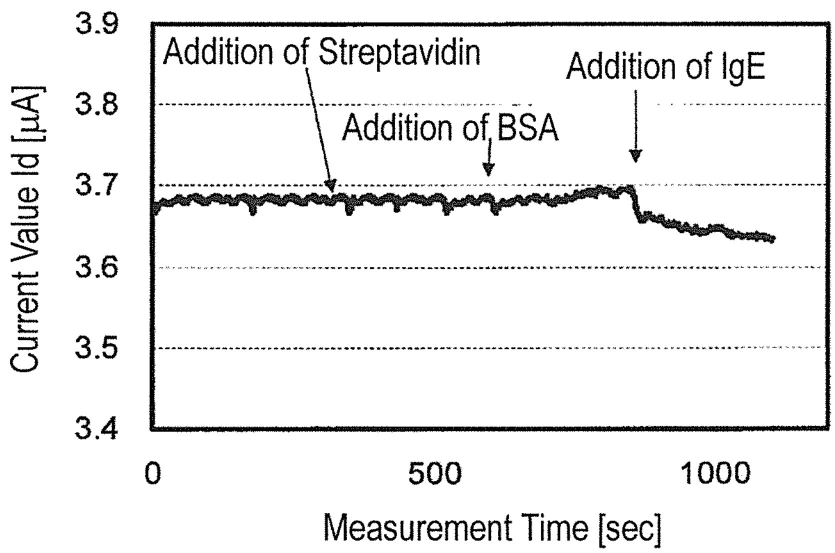
3.9
3.8
3.7
3.6
3.5
3.4
Addition of Streptavidin
Addition of BSA
Addition of IgE
Current Value Id [μA]
0
500
1000
Measurement Time [sec]

FIG. 5

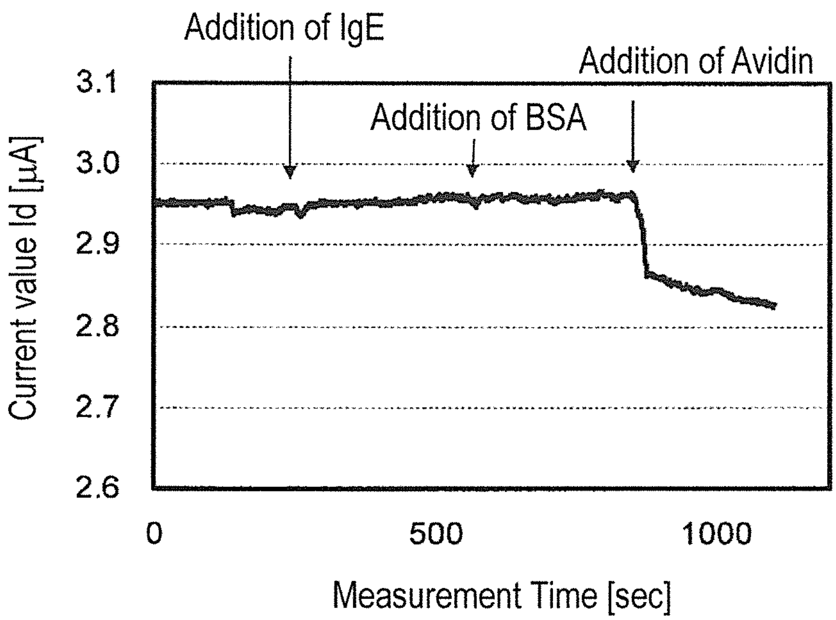
Addition of IgE
Addition of Avidin
Addition of BSA
3.1
3.0
2.9
2.8
2.7
2.6
Current value Id [μA]
0
500
1000
Measurement Time [sec]

**INTERNATIONAL SEARCH REPORT**

International application No.
PCT/JP2014/069003

A. CLASSIFICATION OF SUBJECT MATTER
*C01B31/02*(2006.01)i, *B82Y15/00*(2011.01)i, *B82Y30/00*(2011.01)i, *H01L29/06*(2006.01)i, *H01L29/786*(2006.01)i, *H01L51/05*(2006.01)i, *H01L51/30*(2006.01)i

According to International Patent Classification (IPC) or to both national classification and IPC

B. FIELDS SEARCHED

Minimum documentation searched (classification system followed by classification symbols)
C01B31/00-31/36, B82Y15/00, B82Y30/00, H01L29/06, H01L29/786, H01L51/05, H01L51/30

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2008-277489 A (Toray Industries, Inc.), 13 November 2008 (13.11.2008), claims; examples; molecular structure [29]; fig. 1 to 2 (Family: none) | 1-12 |
| X | JP 2010-225974 A (Toray Industries, Inc.), 07 October 2010 (07.10.2010), claims; examples; molecular structures (77) to (79); fig. 1 to 2 (Family: none) | 1-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 03 October, 2014 (03.10.14) | 28 October, 2014 (28.10.14) |
| Name and mailing address of the ISA/ Japanese Patent Office | Authorized officer |
| Facsimile No. | Telephone No. |

Form PCT/ISA/210 (second sheet) (July 2009)

INTERNATIONAL SEARCH REPORT

International application No.
PCT/JP2014/069003

C (Continuation). DOCUMENTS CONSIDERED TO BE RELEVANT

| Category* | Citation of document, with indication, where appropriate, of the relevant passages | Relevant to claim No. |
|---|---|---|
| X | WO 2009/139339 A1 (Toray Industries, Inc.), 19 November 2009 (19.11.2009), claims; examples; molecular structures [4], [6], [31]; fig. 1 to 2<br>& EP 2287936 A1 & WO 2009/139339 A1<br>& CN 102027612 A & KR 10-2011-0021772 A<br>& TW 201005029 A | 1-12 |
| X | JP 2004-506530 A (William Marsh Rice University), 04 March 2004 (04.03.2004), paragraph [0030]; examples 5, 9<br>& US 2002/0046872 A1 & US 2002/0048632 A1<br>& US 2002/0068170 A1 & US 2004/0186220 A1<br>& US 2010/0143718 A1 & EP 1313900 A<br>& WO 2002/016257 A2 & AU 8665501 A | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007108160 A
- JP 2005229017 A
- JP 2005079342 A


### Non-patent literature cited in the description


- *JOURNAL OF AMERICAN CHEMICAL SOCIETY,* 2007, vol. 129, 14427-14432